# EUROPEAN PATENT APPLICATION

(11) **EP 4 503 436 A1**
(43) Date of publication of application: **05.02.2025**
(21) Application number: 23189757.0
(22) Date of filing: 04.08.2023
(51) Int. Cl.: H03K 3/356

(54) **ELECTRONIC DEVICE FOR SHIFTING A VOLTAGE LEVEL**

(71) Applicant: Nexperia B.V., 6534 AB Nijmegen (NL)
(72) Inventor: Sun, Menghan, Shanghai (CN); Duan, Jianhua, Shanghai (CN)
(74) Representative: Pjanovic, Ilija

(57) **Abstract**

Electronic device for shifting a voltage level; the device comprising: a feedforward component configured for one-shot shifting a first voltage level of a first domain to a third voltage level of a third domain, wherein the third voltage level is different from the first voltage level, via at least one second voltage level of at least one second domain, wherein the at least one second voltage level is different from the first voltage level and from the third voltage level; and a feedback component configured for feeding back the third voltage level from the third domain to the at least one second domain.

## Description

### TECHNICAL FIELD

The present disclosure generally relates to level shifting. Particular embodiments relate to an electronic device for shifting a voltage level.

### BACKGROUND

In the context of power management integrated circuits (PMICs), one-shot level shifting refers to a technique used to convert the voltage level of a signal from one domain to another in a single transition.

PMICs are commonly used to regulate and manage power in electronic devices. They often need to interface with different voltage domains within the device, where each domain operates at a specific voltage level.

One-shot level shifting is employed to perform this voltage conversion in a single transition, minimizing the time required to change voltage levels. It ensures that the transition is completed quickly, without any intermediate voltage states that could lead to undesired behaviour or cause signal integrity issues. This technique helps maintain the integrity and reliability of the signal during the voltage level shift.

By using one-shot level shifting, PMICs can efficiently handle voltage conversion tasks between different domains, facilitating proper communication and interaction between components operating at different voltage levels in electronic devices.

Maintaining signal integrity during level shifting is useful to prevent issues like noise, distortion, or data corruption. Techniques such as noise filtering, impedance matching, and signal conditioning can be employed to minimize signal degradation during the voltage transition, ensuring reliable communication between different voltage domains.

### SUMMARY

It is therefore an aim of at least some embodiments according to the present disclosure to improve level shifting.

Accordingly, there is provided, in a first aspect according to the present disclosure, an electronic device for shifting a voltage level; the device comprising:
- a feedforward component configured for one-shot shifting a first voltage level of a first domain to a third voltage level of a third domain, wherein the third voltage level is different from the first voltage level, via at least one second voltage level of at least one second domain, wherein the at least one second voltage level is different from the first voltage level and from the third voltage level; and
- a feedback component configured for feeding back the third voltage level from the third domain to the at least one second domain.

Because of the inclusion of the feedback component, various embodiments of the electronic device according to the present disclosure may help to improve stability of state transitions even if edge transitions are not sharp, e.g. due to noise within the domains. This may in general help to improve level shifting.

In some embodiments, the feedback component is configured for feeding back the third voltage level only after the feedforward component has achieved the one-shot shifting.

Advantageously, waiting with feedback until after the feedforward has been achieved may help to reduce or even minimize time delays, and may help to ensure that the feedback has a clear, final value (which thus avoids/mitigates incorrect feedback).

In some embodiments, the at least one intermediate voltage level comprises a plurality of intermediate voltage levels, such that the feedforward component spans at least four voltage levels.

Advantageously, this allows application of the electronic device regardless of the overall complexity of the level shifting requirements.

In some embodiments, the feedforward component comprises a first controllable current path controlled by a set signal and a primary output signal. The set signal, SET, corresponds to an input signal, IN; and the primary output signal, OUTP2, is supplied from the second domain.

Said first controllable current path is configured to impose the set signal, SET, onto a primary voltage signal, OUTP3, of the third domain.

The feedback component comprises a second controllable current path controlled by said primary voltage signal, OUTP3, and is configured to feed the primary voltage signal, OUTP3, back to the primary output signal, OUTP2, of the second domain.

In some embodiments, the feedforward component comprises a third controllable current path controlled by a reset signal and a secondary output signal. The reset signal, RESET, is opposite to an or said input signal, IN; and the secondary output signal, OUTN2, is supplied from the second domain.

Said third controllable current path is configured to impose the reset signal, RESET, onto a secondary voltage signal, OUTN3, of the third domain.

The feedback component comprises a fourth controllable current path controlled by said secondary voltage signal, OUTN3, and is configured to feed the secondary voltage signal, OUTN3, back to the secondary output signal, OUTN2, of the second domain.

Additionally, there is provided, in a second aspect according to the present disclosure, a method for shifting a voltage level; the method comprising:
- in a feedforward operation, one-shot shifting a first voltage level of a first domain to a third voltage level of a third domain, wherein the third voltage level is different from the first voltage level, via at least one second voltage level of at least one second domain, wherein the at least one second voltage level is different from the first voltage level and from the third voltage level; and
- in a feedback operation, feeding back the third voltage level from the third domain to the at least one second domain.

In some embodiments, the step of feeding back the third voltage level is performed only after the one-shot shifting has been achieved.

In some embodiments, the at least one intermediate voltage level comprises a plurality of intermediate voltage levels, such that the feedforward operation spans at least four voltage levels.

In some embodiments, the method comprises, in the feedforward operation:
- controlling a first controllable current path by:
   - a set signal, SET, corresponding to an input signal, IN; and
   - a primary output signal, OUTP2, supplied from the second domain; and
- imposing the set signal, SET, onto a primary voltage signal, OUTP3, of the third domain, using said first controllable current path; and
   the method further comprises, in the feedback operation:
   - controlling a second controllable current path by said primary voltage signal, OUTP3; and
   - feeding the primary voltage signal, OUTP3, back to the primary output signal, OUTP2, of the second domain.

In some embodiments, the method comprises, in the feedforward operation:
- controlling a third controllable current path by:
   - a reset signal, RESET, opposite to an or said input signal, IN; and
   - a secondary output signal, OUTN2, supplied from the second domain; and
- imposing the reset signal, RESET, onto a secondary voltage signal, OUTN3, of the third domain, using said third controllable current path; and
   the method further comprises, in the feedback operation:
   - controlling a fourth controllable current path by said secondary voltage signal, OUTN3; and
   - feeding the secondary voltage signal, OUTN3, back to the secondary output signal, OUTN2, of the second domain.

The skilled person will appreciate that various considerations and advantages applying to embodiments of the device according to the present disclosure may apply analogously, *mutatis mutandis*, to embodiments of the method according to the present disclosure, and *vice versa.*

The above-described embodiments are illustrative and are not limiting to the present invention. The skilled person will understand that additional features may be added to the illustrative embodiments described herein, while still falling within the scope determined by the independent claims.

### BRIEF DESCRIPTION OF THE DRAWINGS

In the following description, a number of exemplary embodiments will be described in more detail, to help understanding, with reference to the appended drawings, in which:
Figure 1A schematically illustrates an example of common-floor one-shot feedforward and feedback level shifting;
Figure 1B schematically illustrates an example of common-ceiling one-shot feedforward and feedback level shifting;
Figure 2 schematically illustrates an example of generalized feedforward and feedback level shifting;
Figure 3 schematically illustrates a first exemplary embodiment of an electronic device according to the present disclosure;
Figure 4 schematically illustrates a second exemplary embodiment of an electronic device according to the present disclosure; and
Figures 5A-G schematically illustrate a method of operation of an exemplary embodiment of an electronic device according to the present disclosure, for example the embodiment of Figure 4.

### DETAILED DESCRIPTION

In high slew rate systems (e.g. gate drivers), it is preferred to provide a level-sensitive design. In order to achieve such a level-sensitive design, the inventors have found that the addition of a feedback path may help to bring the states in all domains in sync.

In complex PMICs, unidirectional level shifting is not always sufficient and the relative voltage potential between domains could alternate depending on operating conditions. For example, a first domain may sometimes be at a lower voltage than a second domain, requiring upshifting from the first domain to the second domain, but at other times the first domain may be at a higher voltage than the second domain, requiring downshifting instead.

Prior art designs have struggled because:
- True level sensitivity is not always possible.
- Some designs present a static power.
- General level shifting is not always possible.
- Some designs present a long delay.

However, in some embodiments according to the present disclosure, an intermediary domain may be introduced to achieve general level shifting.

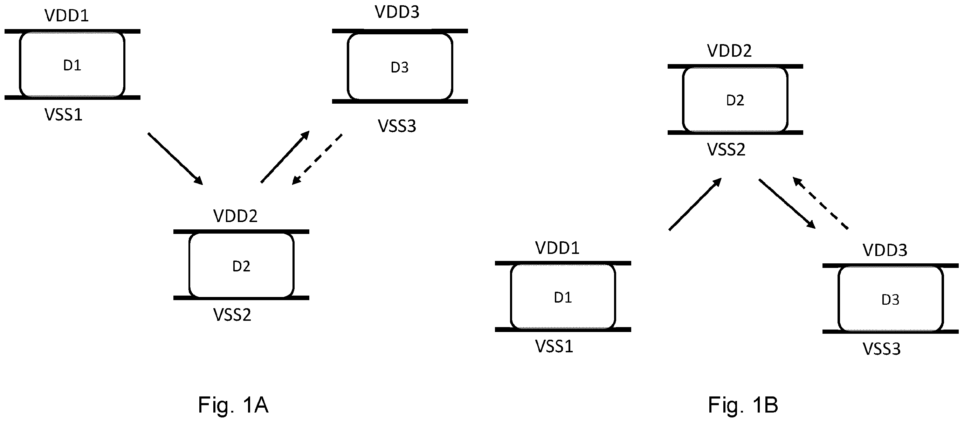

Therefore, in order to mitigate the limitations of unidirectional shifting, and in order to address the above-described struggles encountered by prior art designs, an intermediary, second domain can be used for "signal reflection". This domain can be, either a domain that is always higher than the first and third domain ("the common ceiling") - as is illustrated in Figure 1A, or a domain that is always lower than the first and third domain ("the common floor") - as is illustrated in Figure 1B.

Figure 1A schematically illustrates an example of common-floor one-shot feedforward and feedback level shifting. The figure shows three domains: a first domain D1, a second domain D2, and a third domain D3. All domains can be bounded by corresponding voltage levels VDD and VSS (VDD1, VSS1, VDD2, VSS2, VDD3, VSS3). Voltage can be downshifted from the first domain D1 to the intermediary, second domain D2, and then upshifted from the second domain D2 to the third domain D3. This operation is one-shot level shifting, and is unidirectional. This operation is shown schematically with solid-line arrows going from D1 to D2 and from D2 to D3.

Additionally, in some embodiments according to the present disclosure, a feedback operation may additionally take place, from the third domain D3 back to the second, intermediary domain D2. This operation is shown schematically with a dashed-line arrow going from D3 back to D2.

Analogously, Figure 1B schematically illustrates an example of common-ceiling one-shot feedforward and feedback level shifting. Other than the directions of shifting being opposite to Figure 1A due to the intermediary, second domain D2 being a common ceiling rather than a common floor, this figure is wholly analogous to Figure 1A.

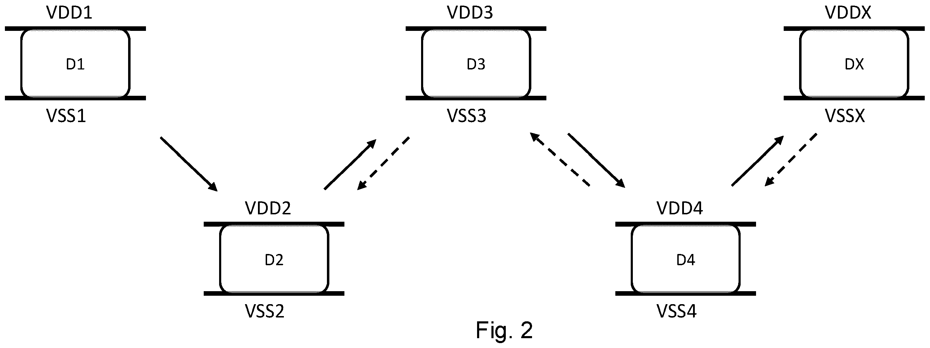

Figure 2 schematically illustrates an example of generalized feedforward and feedback level shifting. This figure is similar to a combination of Figures 1A and 1B, in that voltage is level-shifted from the first domain D1, via multiple intermediary, second domains D2, D3, D4, all the way up to a generally-numbered final domain DX, and that a feedback operation is performed from DX back to D4, from D4 back to D3, and from D3 back to D2. In this sense, domains D2 and D4 serve as common floors, and domain D3 serves as a common ceiling.

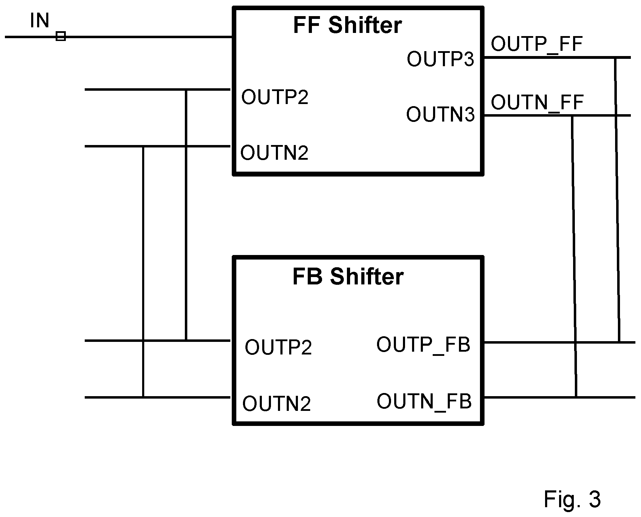

Figure 3 schematically illustrates a first exemplary embodiment of an electronic device according to the present disclosure. The electronic device comprises a feedforward component, designated as "FF Shifter", and a feedback component, designated as "FB Shifter". The electronic device has an input terminal IN, and provides output via output terminals OUTP_FF and OUTN_FF, which mnemonically stand for "output positive feedforward" and "output negative feedforward", respectively. In this context, the notions of "positive" and "negative" should not be interpreted in a literally limiting manner, but can be interpreted as a corresponding binary true version and a complementary binary false version of the input provided via the input terminal IN, respectively.

The feedforward component, FF Shifter, is configured for one-shot shifting a first voltage level of a first domain to a third voltage level of a third domain, wherein the third voltage level is different from the first voltage level, via at least one second voltage level of at least one second domain, wherein the at least one second voltage level is different from the first voltage level and from the third voltage level.

The feedback component, FB Shifter, is configured for feeding back the third voltage level from the third domain to the at least one second domain.

In specific embodiments, the internal circuitry of the feedforward and feedback components may comprise terminals as schematically shown in Figure 3, i.e. the feedforward component may comprise internal output terminals OUTP3 and OUTN3 (designating positive and negative output in the third domain, respectively), which are respectively fed back via the above-described terminals OUTP_FF and OUTN_FF to internal input terminals OUTP_FB and OUTN_FB of the feedback component (designating positive and negative output presented to the feedback component, respectively). The feedforward component and the feedback component may moreover be connected via shared or analogous terminals OUTP2 and OUTN2 (designating positive and negative output in the second domain, respectively). Of course, the first domain may be designed implicit in or following the input terminal IN.

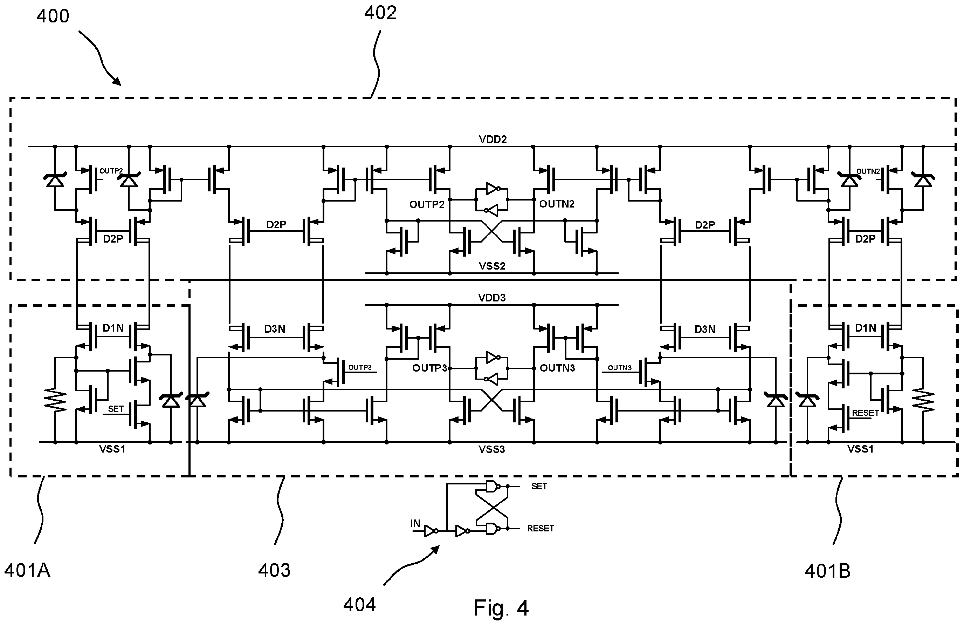

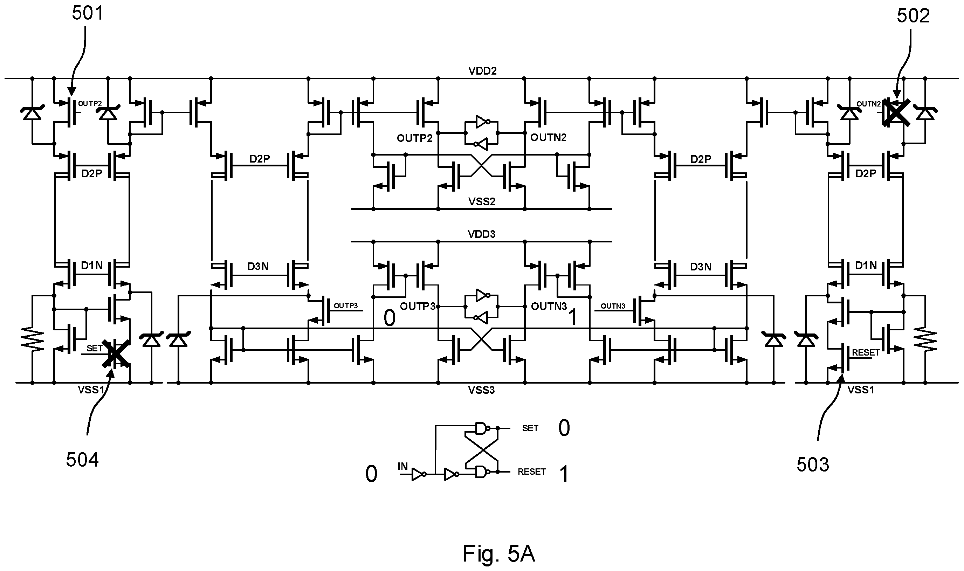

Figure 4 schematically illustrates a second exemplary embodiment of an electronic device 400, for shifting a voltage level, according to the present disclosure. The figure shows the electronic device 400 comprising a feedforward component and a feedback component. In this second exemplary embodiment, the feedforward and feedback components span three domains (as will be explained with reference to Figures 5A-G), namely a first domain 401A, 401B (wherein 401A corresponds with the positive and 401B with the negative version, as described above), a second domain 402, and a third domain 403. For the sake of clarity, the figure also shows circuitry 404 to produce a set signal SET and a reset signal RESET based on the input signal IN, such that SET corresponds with IN and RESET is opposite to IN.

In this second exemplary embodiment too, the feedforward component is configured for one-shot shifting a first voltage level of the first domain 401A, 401B to a third voltage level of a third domain 403, wherein the third voltage level is different from the first voltage level, via at least one second voltage level of at least one second domain 402 (in this case exactly one second domain 402), wherein the at least one second voltage level is different from the first voltage level and from the third voltage level. Also, the feedback component is configured for feeding back the third voltage level from the third domain 403 to the at least one second domain 402.

In this second exemplary embodiment, as well as in various other further developed embodiments according to the present disclosure, LV current mirrors may be employed to create a positive feedback loop for state changes and enforcement, HV devices may provide cascading of the LV devices, and a FB shifter may be used to sync the states for the multiple domains. Moreover, HV cascaded current mirrors may be used to create positive feedback for state transition and enforcement.

In this manner, this feedback level shifter can be used to sync the states between all domains to achieve true level sensitivity, which makes the electronic device robust against perturbation. Moreover, these embodiments provide general level shifting, wherein the sign of the relative potential can alternate during operation. Additionally, a low delay may be achieved because the feedback actions is mainly realized by LV devices. Additionally, the feedback component is not in the way of the feedforward component, and hence it doesn't affect the delay, making overall operation faster.

A further advantage of the presently described transistor-based arrangement of this exemplary embodiment is that it has a reduced static power consumption, as opposed to resistor-based arrangements of the prior art.

Figures 5A-G schematically illustrate a method of operation of an exemplary embodiment of an electronic device according to the present disclosure, for example the electronic device embodiment 400 of Figure 4.

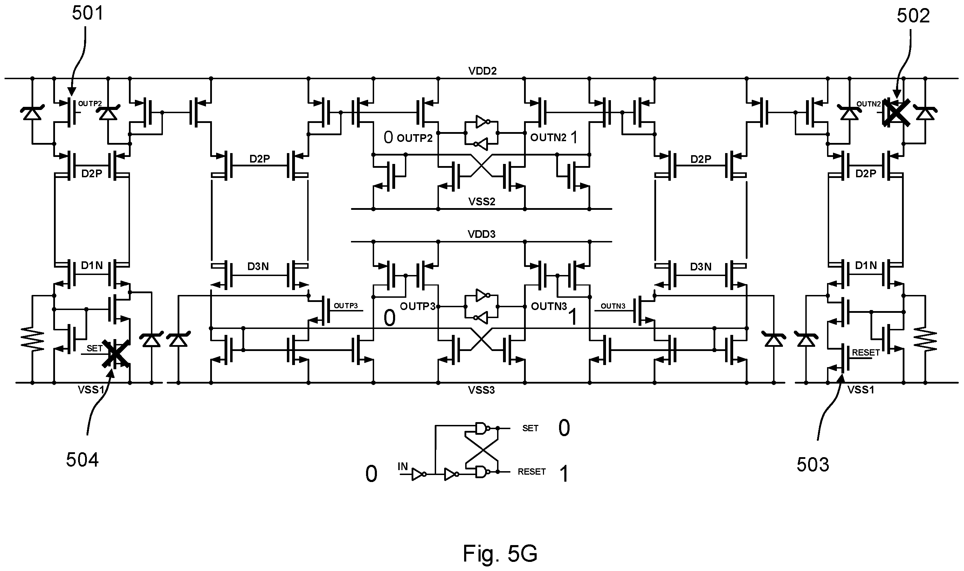

In Figure 5A, which can be summarized as "RESET, IN=OUT=0", a stable situation is shown, wherein the input signal IN is at 0, producing 0 at SET and 1 at RESET. Thus, the 0 for SET blocks transistor 504, and the 1 for RESET conducts transistor 503. In this stable situation, OUTP3 is at 0 and OUTN3 is at 1. Transistor 501 conducts due to OUTP3 being high and transistor 502 is blocked due to OUTN2 being low (cf. Figure 5G).

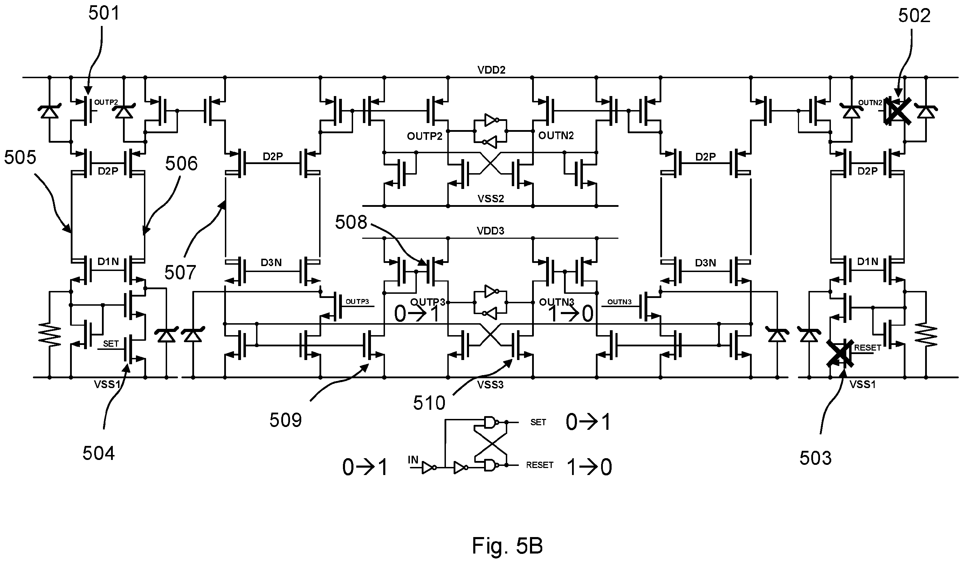

In Figure 5B, which can be summarized as "RESET→SET, IN:0→1, OUT:0→1, FF" (where FF stands for feedforward), IN is brought to 1 from 0, such that SET is brought to 1 from 0 and RESET is brought to 0 from 1. Therefore, SET makes transistor 504 conduct, and RESET blocks transistor 503. This in turn produces current in branches 505, 506, 507, 508, 509 and 510. This current, which is controlled by the SET signal, can be seen as the feedforward operation, and the circuitry involved can be seen as the feedforward component. Due to this operation, OUTP3 is brought to 1 from 0, and OUTN3 is brought to 0 from 1.

Hypothetically, if operation would now be halted after this feedforward operation has been achieved but before any feedback operation is performed, and if the rest of the circuitry would be rendered ineffective, the output would be brought to where it needs to be, but stability cannot be guaranteed as well. Therefore, it is preferred to include feedback.

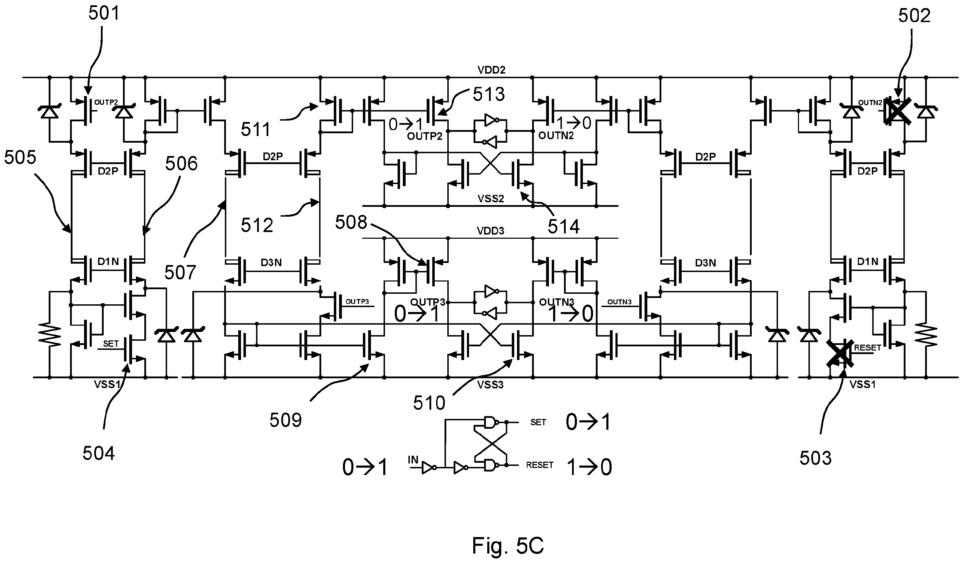

In Figure 5C, which can be summarized as "RESET→SET, IN:0→1, OUT:0→1, FB" (where FB stands for feedback), the rise of OUTP3 from 0 to 1 causes current in branches 511, 512, 513 and 514 (due to the transistor controlled by OUTP3). This in turn brings OUTP2 from 0 to 1, and OUTN2 from 1 to 0. In this sense, the second domain has come to mirror the first domain, via feedback from the third domain. Thus, this operation can be seen as the feedback operation, and the circuitry involved can be seen as the feedback component. In other words, the feedback component may be configured for feeding back the third voltage level only after the feedforward component has achieved the one-shot shifting, which corresponds here with the feedforward operation.

Also in other words, the feedforward component may comprise a first controllable current path 505, 506, 507, 508, 509, 510 controlled 501, 504 by:
- a set signal, SET, corresponding to an input signal, IN; and
- a primary output signal, OUTP2, supplied from the second domain;
wherein said first controllable current path may be configured to impose the set signal, SET, onto a primary voltage signal, OUTP3, of the third domain; and
wherein the feedback component may comprise a second controllable current path 511, 512, 513, 514 controlled by said primary voltage signal, OUTP3, and which may be configured to feed the primary voltage signal, OUTP3, back to the primary output signal, OUTP2, of the second domain.

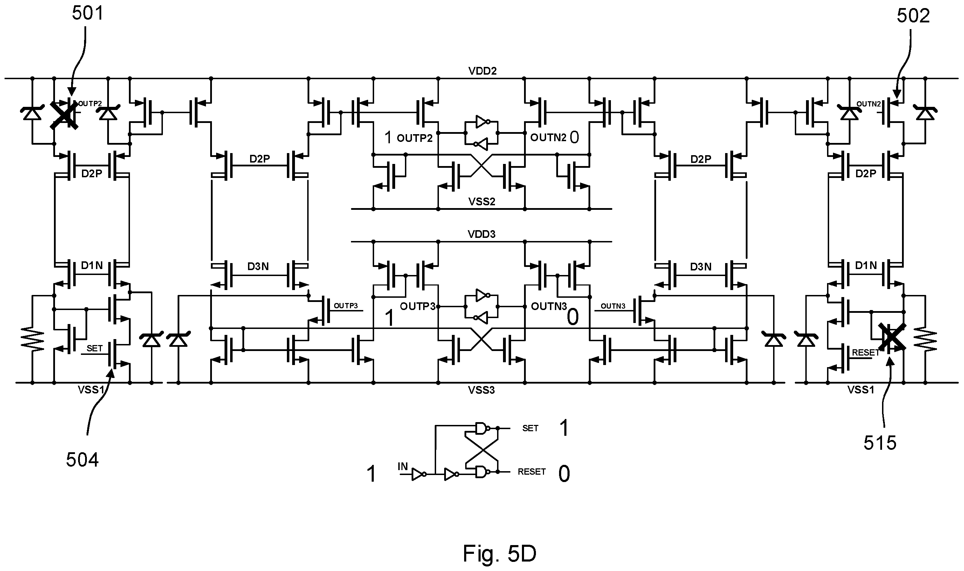

In Figure 5D, which can be summarized as "SET done, IN=1, OUT=1", the outcome of Figure 5C can be seen, wherein OUTP2 (which is at 1) now blocks transistor 501 and OUTN2 (which is at 0) conducts transistor 502.

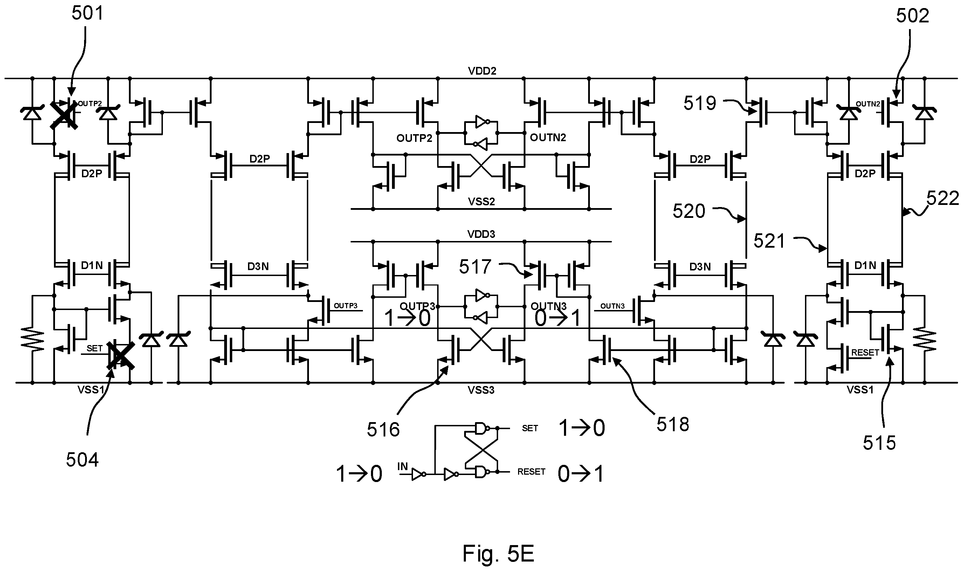

In Figure 5E, which can be summarized as "SET→RESET, IN:1→0, OUT:0→1, FF", the IN signal is brought to 0 from 1, such that SET is brought to 0 from 1 and RESET is brought to 1 from 0. Thus, SET now blocks transistor 504, and transistor 515 conducts. This produces current in branches 516, 517, 518, 519, 529, 521 and 522. This in turn brings OUTP3 to 0 from 1, and OUTN3 to 1 from 0. This current can be seen as the feedforward operation, and the circuitry involved can be seen as the feedforward component.

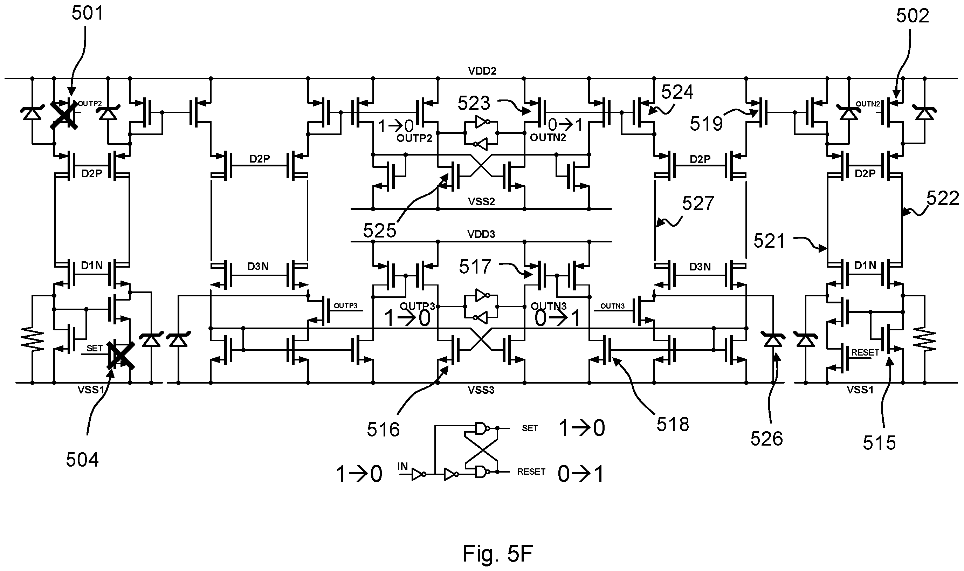

In Figure 5F, which can be summarized as "SET→RESET, IN:1→0, OUT:0→1, FB", the rise of OUTN3 from 0 to 1 causes current in branches 523, 524, 525, 526 and 527. This in turn brings OUTP2 from 1 to 0, and OUTN2 from 0 to 1. In this sense, the second domain has come to mirror the first domain, via feedback from the third domain. Thus, this operation can be seen as the feedback operation, and the circuitry involved can be seen as the feedback component.

Thus, in other words, the feedforward component may comprise a third controllable current path 515, 516, 517, 518, 519, 520, 521, 522 controlled 502 by:
- a reset signal, RESET, opposite to an or said input signal, IN; and
- a secondary output signal, OUTN2, supplied from the second domain;
wherein said third controllable current path may be configured to impose the reset signal, RESET, onto a secondary voltage signal, OUTN3, of the third domain; and
wherein the feedback component may comprise a fourth controllable current path 523, 524, 525, 526, 527 controlled by said secondary voltage signal, OUTN3, and which may be configured to feed the secondary voltage signal, OUTN3, back to the secondary output signal, OUTN2, of the second domain.

In Figure 5G, which can be summarized as "RESET done, IN=0, OUT=0", the outcome of Figure 5F can be seen, wherein OUTP2 (which is at 0) now conducts transistor 501 and OUTN2 (which is at 1) now blocks transistor 502.

As used in this application and in the claims, the singular forms "a," "an," and "the" include the plural forms unless the context clearly dictates otherwise. The systems, apparatus, and methods described herein should not be construed as limiting in any way. Instead, the present disclosure is directed toward all novel and non-obvious features and aspects of the various disclosed embodiments, alone and in various combinations and sub-combinations with one another. The disclosed systems, methods, and apparatus are not limited to any specific aspect or feature or combinations thereof, nor do the disclosed systems, methods, and apparatus require that any one or more specific advantages be present or problems be solved. Any theories of operation are to facilitate explanation, but the disclosed systems, methods, and apparatus are not limited to such theories of operation.

Although the operations of some of the disclosed methods are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed systems, methods, and apparatus can be used in conjunction with other systems, methods, and apparatus. Additionally, the description sometimes uses terms like "obtaining" and "outputting" to describe the disclosed methods. These terms are high-level abstractions of the actual operations that are performed. The actual operations that correspond to these terms will vary depending on the particular implementation and are readily discernible by the skilled person.

It will be appreciated that for simplicity and clarity of illustration, where appropriate, reference numerals may have been repeated among the different figures to indicate corresponding or analogous elements. In addition, numerous specific details are set forth in order to provide a thorough understanding of the examples described herein. However, it will be understood by the skilled person that the examples described herein can be practiced without these specific details. In other instances, methods, procedures and components have not been described in detail so as not to obscure the related relevant feature being described. The drawings are not necessarily to scale and the proportions of certain parts may be exaggerated to better illustrate details and features. The description is not to be considered as limiting the scope of the examples described herein.

### LIST OF REFERENCE NUMBERS

- 400: electronic device
- 401A, 401B: first domain
- 402: second domain
- 403: third domain
- 404: set/reset circuitry
- 501, 502, 503, 504: transistors controlled by OUTP2, OUTN2, RESET and SET respectively
- 505, 506, 507, 508, 509, 510: current branches
- 511, 512, 513, 514: current branches
- 515, 516, 517, 518, 519, 520, 521, 522: current branches
- 523, 524, 525, 526, 527: current branches
- 505, 506, 507, 508, 509, 510: first controllable current path
- 511, 512, 513, 514: second controllable current path
- 515, 516, 517, 518, 519, 520, 521, 522: third controllable current path
- 523, 524, 525, 526, 527: fourth controllable current path

## Claims

1. An electronic device for shifting a voltage level; the device comprising:
- a feedforward component configured for one-shot shifting a first voltage level of a first domain to a third voltage level of a third domain, wherein the third voltage level is different from the first voltage level, via at least one second voltage level of at least one second domain, wherein the at least one second voltage level is different from the first voltage level and from the third voltage level; and
- a feedback component configured for feeding back the third voltage level from the third domain to the at least one second domain.

2. The device of claim 1, wherein the feedback component is configured for feeding back the third voltage level only after the feedforward component has achieved the one-shot shifting.

3. The device of any one of claims 1-2, wherein the at least one intermediate voltage level comprises a plurality of intermediate voltage levels, such that the feedforward component spans at least four voltage levels.

4. The device of any one of claims 1-3, wherein the feedforward component comprises a first controllable current path controlled by:
- a set signal, SET, corresponding to an input signal, IN; and
- a primary output signal, OUTP2, supplied from the second domain;
wherein said first controllable current path is configured to impose the set signal, SET, onto a primary voltage signal, OUTP3, of the third domain; and
wherein the feedback component comprises a second controllable current path controlled by said primary voltage signal, OUTP3, and configured to feed the primary voltage signal, OUTP3, back to the primary output signal, OUTP2, of the second domain.

5. The device of any one of claims 1-4,
wherein the feedforward component comprises a third controllable current path controlled by:
- a reset signal, RESET, opposite to an or said input signal, IN; and
- a secondary output signal, OUTN2, supplied from the second domain;
wherein said third controllable current path is configured to impose the reset signal, RESET, onto a secondary voltage signal, OUTN3, of the third domain; and
wherein the feedback component comprises a fourth controllable current path controlled by said secondary voltage signal, OUTN3, and configured to feed the secondary voltage signal, OUTN3, back to the secondary output signal, OUTN2, of the second domain.

6. A method for shifting a voltage level; the method comprising:
- in a feedforward operation, one-shot shifting a first voltage level of a first domain to a third voltage level of a third domain, wherein the third voltage level is different from the first voltage level, via at least one second voltage level of at least one second domain, wherein the at least one second voltage level is different from the first voltage level and from the third voltage level; and
- in a feedback operation, feeding back the third voltage level from the third domain to the at least one second domain.

7. The method of claim 6, wherein the step of feeding back the third voltage level is performed only after the one-shot shifting has been achieved.

8. The method of any one of claims 6-7, wherein the at least one intermediate voltage level comprises a plurality of intermediate voltage levels, such that the feedforward operation spans at least four voltage levels.

9. The method of any one of claims 6-8, comprising, in the feedforward operation:
- controlling a first controllable current path by:
- a set signal, SET, corresponding to an input signal, IN; and
- a primary output signal, OUTP2, supplied from the second domain; and
- imposing the set signal, SET, onto a primary voltage signal, OUTP3, of the third domain, using said first controllable current path; and
the method further comprising, in the feedback operation:
- controlling a second controllable current path by said primary voltage signal, OUTP3; and
- feeding the primary voltage signal, OUTP3, back to the primary output signal, OUTP2, of the second domain.

10. The method of any one of claims 6-9, comprising in the feedforward operation:
- controlling a third controllable current path by:
- a reset signal, RESET, opposite to an or said input signal, IN; and
- a secondary output signal, OUTN2, supplied from the second domain; and
- imposing the reset signal, RESET, onto a secondary voltage signal, OUTN3, of the third domain, using said third controllable current path; and
the method further comprising, in the feedback operation:
- controlling a fourth controllable current path by said secondary voltage signal, OUTN3; and
- feeding the secondary voltage signal, OUTN3, back to the secondary output signal, OUTN2, of the second domain.
